# FASCICULE DE BREVET EUROPEEN

(11) **EP 1 069 813 B1**
(45) Date de publication et mention de la délivrance du brevet: **05.01.2011**
(21) Numéro de dépôt: 00401861.0
(22) Date de dépôt: 29.06.2000
(51) Int. Cl.: H05K 7/14

(54) **Face avant de carte électronique, carte électronique et procédé d'insertion ou d'extraction d'une telle carte dans un boîtier**
Frontplatte für eine elektronische Baugruppe, elektronische Baugruppe, und deren Einschub- oder Ausziehverfahren aus einem Baugruppenträger
Electronic card front plate, electronic plate and its inserting or extracting method in a rack

(30) Priorité: 12.07.1999 FR 9909201
(43) Date de publication de la demande: 17.01.2001
(73) Titulaire: ALSTOM Transport SA, 92300 Levallois-Perret (FR)
(72) Inventeur: Ruque, Christian, 69960 Corbas (FR)

(56) Documents cités:
- DE-U- 29 610 693
- FR-A- 2 599 927
- FR-A- 2 723 667
- FR-A- 2 743 977
- US-A- 4 307 510
- PATENT ABSTRACTS OF JAPAN vol. 1995, no. 01, 28 février 1995 (1995-02-28) & JP 06 302979 A (NEC CORP), 28 octobre 1994 (1994-10-28)

## Description

L'invention a trait à une face avant de carte électronique, à une carte électronique prévue pour être insérée dans un boîtier et à un procédé d'insertion ou d'extraction d'une telle carte dans un tel boîtier.

Il est connu de réaliser des boîtiers dans lesquels sont disposées côte à côte des cartes électroniques, de tels boîtiers étant destinés à constituer des unités de contrôle ou de commande de divers matériels électriques. En général, un tel boîtier, qui peut être fixe ou constituer un tiroir, comprend une ouverture en face avant à travers laquelle sont introduites les cartes, alors que sa face arrière est pourvue de moyens de connexion destinés à coopérer avec chacune des cartes.

Compte tenu des évolutions récentes des techniques de connexion des cartes qui incluent des dispositifs du type "bus compact PCI" ou des connecteurs selon la norme CEI 1076-4-101, les efforts nécessaires pour la mise en place ou le retrait de telles cartes dans un boîtier correspondant sont importants, leur manoeuvre, notamment en fin d'insertion dans le boîtier ou en début d'extraction, étant difficile.

Pour pallier cet inconvénient, il est connu, par exemple de US-A-5,504,656, d'articuler en partie basse de la face avant d'une carte électronique un dispositif pourvu d'ergots prévus pour pénétrer dans des encoches d'un profil disposé sur le bord de l'ouverture du boîtier. Un bras de manoeuvre permet de faire pivoter ce dispositif par rapport à ces encoches. Ce dispositif occupe une place importante sur la face avant de la carte et, lorsque plusieurs cartes sont juxtaposées dans un boîtier, l'ensemble des dispositifs correspondants est relativement encombrant, alors que leur coût unitaire est élevé par rapport au prix de revient de la carte. En particulier, le fait d'intégrer un dispositif de manoeuvre dans chaque face avant impose de réaliser cette face avant en plusieurs parties et de monter plusieurs pièces accessoires telles qu'un axe de rotation et des vis d'assemblage, ce qui est à la fois complexe et onéreux. Or, un tel dispositif doit être installé sur chacune des cartes, ce qui majore d'autant le prix de revient d'une unité de contrôle ou de commande équipée de plusieurs cartes. En outre, en position engagée des ergots dans les encoches du profil, ce dispositif masque une vis de fixation de la carte sur le boîtier, ce qui crée un risque d'oubli du serrage de cette vis lors de l'insertion de la carte, un déplacement de la carte par rapport au boîtier ne pouvant être exclu. En particulier, aucun contrôle visuel direct du bon serrage de la vis de fixation de la carte ne peut être effectué par un opérateur. En outre, un tel dispositif réduit la surface accessible sur la face avant de la carte, ce qui interdit l'emploi de connecteurs normalisés selon une norme DIN et de coût modique et la mise en place d'un dispositif de centrage permettant de réaliser un tiroir dit "débrochable", tel que décrit dans FR-A-2 743 977. Enfin, un tel dispositif doit être adapté en fonction du type de connectique utilisé entre la carte et la face arrière du boîtier, de telle sorte qu'il arrive qu'un même boîtier soit équipé de différents types de faces avant et de tels dispositifs, ce qui induit une gestion relativement complexe, notamment pour la maintenance d'une unité électronique.

C'est à ces inconvénients qu'entend plus particulièrement remédier l'invention en proposant une nouvelle structure de face avant pour une carte électronique qui permet une insertion et une extraction aisées sans avoir recours à un dispositif spécifique complexe tel que connu de l'état de la technique.

Dans cet esprit, l'invention concerne une face avant de carte électronique telle que définie dans la revendication 1.

Grâce à l'invention, il est possible de terminer le mouvement d'insertion ou de commencer le mouvement d'extraction de la carte en prenant appui sur la surface prévue à cet effet, de façon à exercer sur celle-ci un effort intense dirigé vers le fond du boîtier ou à l'opposé de celui-ci. L'organe de manoeuvre peut être dimensionné de façon telle qu'il permet de déplacer la carte sans effort excessif, notamment grâce à un effet de levier. Il n'est pas prévu de dispositif de manoeuvre résidant sur la face avant, d'où une forte diminution du prix de revient d'une telle face avant. Enfin, la face avant de l'invention peut être monobloc, ce qui lui confère une bonne rigidité.

comprend deux surfaces d'appui inclinées dans deux sens différents par rapport à un plan longitudinal, l'une de ces surfaces d'appui étant apte à coopérer avec l'organe de manoeuvre pour l'insertion de la carte dans le boîtier, alors que l'autre surface d'appui est apte à coopérer avec cet organe de manoeuvre pour l'extraction de la carte. Ces deux surfaces d'appui sont avantageusement inclinées l'une par rapport à l'autre d'un angle compris entre 60 et 90°, de préférence de l'ordre de 70°. On peut en outre prévoir que ces surfaces d'appui sont dimensionnées et positionnées par rapport à la face avant de telle sorte qu'un bord commun à ces surfaces d'appui est disposé sensiblement en regard du bord intérieur d'une encoche du profil, en configuration montée de la carte dans le boîtier. Ainsi, il est possible d'insérer l'organe de manoeuvre à travers l'encoche pour interagir avec l'une ou l'autre de ses surfaces d'appui, en fonction de la direction souhaitée de l'effort à exercer sur la face avant et sur la carte. Dans des réalisations avantageuses de l'invention :
- La face avant comprend au moins une surface d'appui telle que précédemment définie à chacune de ses extrémités inférieure et supérieure, ce qui permet d'obtenir les avantages précités au niveau des deux bords de l'ouverture d'un boîtier lorsque ces deux bords sont équipés d'un profil à encoches.
- La surface d'appui est formée lors du moulage de la face avant. La face avant est, de façon préférentielle, réalisée en zamack car ce matériau présente de bonnes caractéristiques de moulage, une bonne rigidité et une bonne conductibilité, y compris après nickelage. Ainsi, le prix de revient marginal d'une telle surface d'appui est nul puisqu'elle est obtenue sans sur-coût supplémentaire par rapport à une opération de moulage d'une face avant de l'état de la technique.
- La surface d'appui est ménagée légèrement en retrait d'un bord supérieur ou inférieur de la face avant, dans l'épaisseur de cette face avant.

L'invention concerne également une carte électronique telle que définie dans la revendication 7 Une telle carte électronique est plus facile à manipuler que celles de l'état de la technique, alors qu'elle est plus fiable et que son prix de revient est inférieur à celles équipées d'un dispositif tel que connu de US-A-5,504,656.

L'invention concerne également un procédé d'insertion ou d'extraction tels que définis dans la revendication 8.

Le procédé de l'invention est particulièrement simple à mettre en oeuvre, puisqu'il suffit d'utiliser un unique organe de manoeuvre pour mettre successivement en place plusieurs cartes dans un boîtier ou extraire successivement plusieurs cartes d'un boîtier. Cet organe de manoeuvre est avantageusement un tournevis qui doit, dans tous les cas, être utilisé pour le serrage ou le desserrage d'une vis de fixation de la carte dans le boîtier. Comme un effet de levier est utilisé par le pivotement ou le basculement du tournevis par rapport à sa zone d'appui dans l'encoche du profil, un effort intense peut être transmis à la face avant, ce qui permet de vaincre les efforts résistants générés au niveau des dispositifs de connexion entre la carte et la face arrière du boîtier.

L'invention sera mieux comprise et d'autres avantages de celle-ci apparaîtront plus clairement à la lumière de la description qui va suivre d'un mode de réalisation d'une carte électronique conforme à l'invention et de son procédé d'insertion ou d'extraction dans un boîtier, donnée uniquement à titre d'exemple et faite en référence aux dessins annexés dans lesquels :
- la figure 1 est une représentation schématique partielle de principe d'une carte conforme à l'invention en cours d'introduction dans un boîtier ;
- la figure 2 est une vue partielle de côté de la carte de la figure 1 lors d'une étape finale d'insertion dans le boîtier ;
- la figure 3 est une vue partielle de côté d'une partie supérieure de la figure 1 lors d'une étape initiale d'extraction par rapport au boîtier et
- la figure 4 est une vue analogue à la figure 2 pour une seconde configuration d'utilisation d'une carte conforme à l'invention.

La carte électronique 1 représentée sur les figures est équipée d'une face avant 2 et de moyens de connexions 3. Elle est destinée à être mise en place dans un boîtier 4 dont la face arrière 5 est équipée de moyens de connexions 6 aptes à coopérer avec les moyens 3. Le boîtier 4 est pourvu, sur sa face avant 7 d'une ouverture 8 à travers laquelle la carte 1 est prévue pour être introduite jusqu'à ce que les moyens 3 et 6 coopèrent efficacement, la carte 1 devant alors être immobilisée dans cette position. Le mouvement d'insertion de la carte est, pour l'essentiel, réalisé en poussant la face avant 2 en direction de la face arrière 5 du boîtier 4, comme représenté par la flèche F₁. Ce mouvement a lieu par coulissement de la carte 1 dans deux glissières 11 et 12, encliquetées en parties haute et basse du boîtier et prévues pour recevoir et guider les bords haut et bas de la carte 1.

Les bords supérieur et inférieur de l'ouverture 8 sont chacun équipés d'un profil 9 ou 10 à encoches, par exemple du type prévu par la norme IEEE NE P 1101.10.

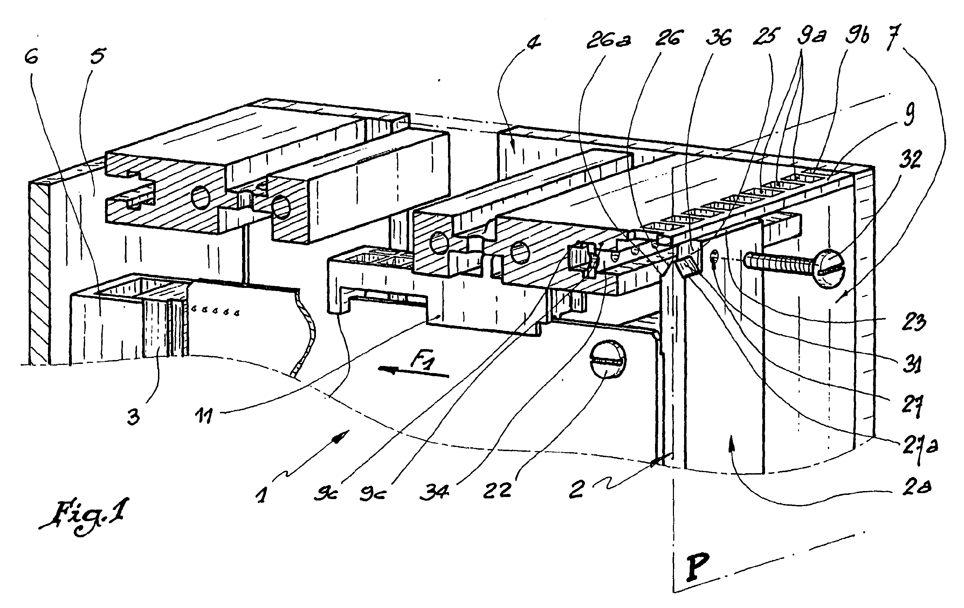

La face avant 2 est réalisée en zamack par moulage. Elle est fixée sur la carte 1 par des vis, dont une est visible à la figure 1 avec la référence 22, de telle sorte qu'elle forme un ensemble unitaire avec cette carte.

On note respectivement 23 et 24 les bords supérieur et inférieur 24 de la face avant 2. Le bord 23 ne s'étend pas sur toute la largeur de la face avant 2 mais est pourvu d'un décrochement 25 dans lequel sont formées deux surfaces 26 et 27, inclinées par rapport à un plan longitudinal P de la partie de la face avant 2 contenant les bords 23 et 24. Les surfaces 26 et 27 sont formées dans l'épaisseur e du bord 23 en retrait d'une hauteur h par rapport au bord 23.

En partie inférieure, c'est-à-dire au niveau de leurs raccordements respectifs avec les surfaces principales avant 2a et arrière 2b de la face avant 2, les surfaces 26 et 27 sont respectivement bordées par une bande plane 26a ou 27a, globalement perpendiculaire aux surfaces 2a et 2b.

De la même manière, des surfaces inclinées 28 et 29 sont ménagées à proximité du bord inférieur 24 de la face avant 2, dans son épaisseur, et l'on note 28a et 29a des bandes planes qui les bordent.

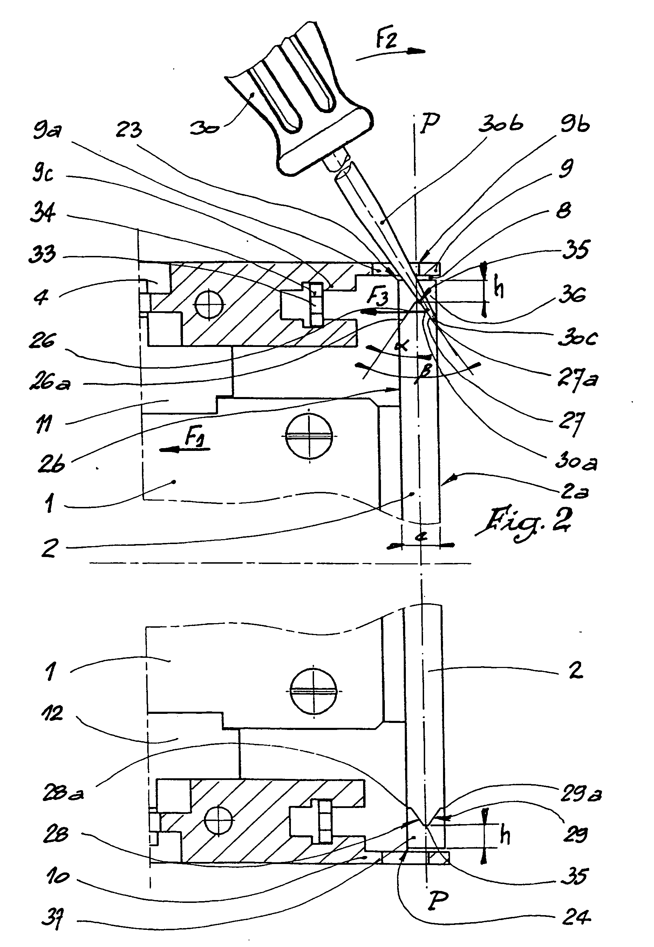

Comme il ressort plus clairement de la figure 2, les surfaces 26 et 27 sont chacune inclinées par rapport au plan P d'un angle α compris entre 30° et 45°, et de préférence égal à 35°. Ainsi, l'angle β d'inclinaison des surfaces 26 et 27 l'une par rapport à l'autre est compris entre 61°et 90° et de préférence de l'ordre de 70°. Il en est de même pour les surfaces 28 et 29.

Lorsque la carte 1 a été présentée dans le boîtier 4 de façon telle que ses moyens de connexions 3 sont à proximité ou en contact avec les moyens de connexions 6, il convient de vaincre un effort résistant important pour enclencher des moyens coopérants 3 et 6.

Pour ce faire, on introduit l'extrémité 30a d'un tournevis 30 dans une encoche 9a du profil 9 en la faisant porter contre la surface 27. L'introduction de l'extrémité 30a du tournevis 30 dans l'encoche 9a a lieu jusqu'à ce que l'arête 30c du tournevis 30 porte contre la bande 27a. Ceci permet une mise en place "en aveugle" de l'extrémité 30a contre la surface 27. La tige 30b du tournevis 30 porte contre le bord 9b de l'encoche 9 situé du côté extérieur de l'encoche, c'est-à-dire à l'opposé du volume intérieur du boîtier 4. Ainsi, un mouvement de pivotement ou de basculement du tournevis 30 autour de la zone d'appui de la tige 30 sur le bord 9b, tel que représenté par la flèche F₂, a pour effet de transmettre à la surface 27, et par là même à la face avant 2, un effort représenté par la flèche F₃ et dirigé vers la face arrière 5 du boîtier 4.

Un effet de levier important est obtenu grâce au tournevis 30 dans la mesure où le bord 9b de l'encoche 9a est proche de la face 27 alors que la tige 30b du tournevis peut avoir une longueur relativement importante. C'est pourquoi, l'effort F₃ peut être intense, et en particulier suffisant pour vaincre les efforts de réaction s'opposant à la connexion des moyens 3 et 6. Les surfaces 26 à 29 sont globalement coplanaires avec la carte 1, ce qui implique que la transmission de l'effort entre le tournevis 30 et la carte 1 a lieu globalement dans le plan de la carte, aucun effort de torsion n'étant créé au niveau de la face avant 2. En pratique l'effort F₃ est coplanaire aux bords supérieur et inférieur de la carte 1, ce qui facilite leur glissement dans les glissières 11 et 12. L'effort exercé par l'utilisateur sur le tournevis 30 peut donc être relativement modeste.

Comme il ressort plus clairement de la figure 1, un orifice 31 est prévu sur la face avant 2 pour le passage d'une vis 32 de fixation sur le bord 8a de l'ouverture 8, la vis 32 étant destinée à pénétrer dans un taraudage 33 prévu à cet effet dans une barrette 34 maintenue en position dans le profil 9 par des retours 9c façonnés par filage sur le profil. Ainsi, la mise en place d'une carte 1 requiert l'utilisation d'un tournevis pour le serrage de la vis 32 en position. Il est donc naturel pour l'opérateur de disposer d'un tel tournevis, de sorte que le procédé décrit ci-dessus permettant d'exercer un effort important sur la face avant 2 est réalisé sans utilisation d'un outillage spécifique.

En outre, l'orifice 31 de la face avant 2 demeure en permanence visible pour l'opérateur qui n'est pas gêné pour manoeuvrer la vis 32, et pour procéder au contrôle visuel de son serrage.

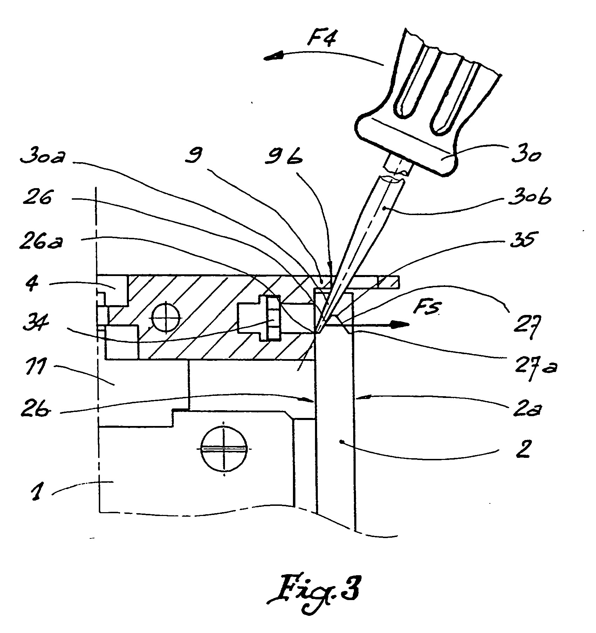

Lorsqu'il est nécessaire d'extraire la carte 1 du boîtier 4, le tournevis 30 est utilisé comme représenté à la figure 3 où sa tige 30b vient en appui contre le bord 9b de l'encoche 9a du côté du volume intérieur du boîtier 4 alors que son extrémité 30a est en appui contre la surface 26. Par un effet de levier analogue à celui précédemment décrit, un basculement ou pivotement du tournevis 30, représenté par la flèche F₄, a pour effet de générer sur la surface 26 un effort, représenté par la flèche F₅, suffisant pour vaincre les frottements générés au niveau des moyens de connexions 3 et 6 au début de l'extraction de la carte 1 du boîtier 4.

La figure 3 représente la face avant 2 en position montée de la carte 1 et l'on note que l'arête 35 qui est commune aux surfaces 26 et 27 est disposée sensiblement en regard du bord intérieur 9b de l'encoche 9a, du côté du volume intérieur du boîtier 4, de telle sorte que dans cette position, le tournevis peut être introduit pour coopérer avec la surface 26 ou la surface 27 en fonction de la direction de l'effort souhaité, pour l'insertion ou pour l'extraction de la carte 1.

L'arête 35 est arrondie pour faciliter la mise en place "en aveugle" de l'extrémité 30a, dans la position de la figure 2 ou dans celle de la figure 3.

Comme des surfaces inclinées 26, 27, 28 et 29 sont prévues à proximité des bords supérieur et inférieur 23 et 24 de la face avant 2, le procédé décrit ci-dessus peut être mis en oeuvre au niveau des bords supérieur 23 et inférieur 24 en fonction de l'environnement de la carte 1. En particulier, lorsque le boîtier 4 comprend deux rangées de cartes superposées, il est possible d'intervenir avec un tournevis sur le bord supérieur de la face avant d'une carte de la rangée supérieure et sur le bord inférieur de la face avant d'une carte de la rangée inférieure.

Cependant, il est possible d'équiper l'ouverture 8 du boîtier 4 d'un seul profil à encoches si l'accès à ce profil n'est pas gêné par l'environnement du boîtier. En effet, il suffit d'agir uniquement sur l'un des bords 23 ou 24 de la face avant 2 pour manoeuvrer la carte 1.

Les surfaces 26 à 29 et les bandes 26a à 29a sont ménagées dans l'épaisseur des bords 23 et 24 légèrement en retrait par rapport à ceux-ci, de sorte qu'elles sont protégées lors des manoeuvres de la carte à l'extérieur du boîtier et qu'elles ne risquent pas d'être endommagées. Ces surfaces inclinées sont obtenues lors du moulage de la face avant 2 et elles ne modifient pas le prix de revient unitaire d'une telle face avant.

De par la géométrie des surfaces 26 à 29, deux faces latérales 36 et 37 sont créées respectivement au voisinage des surfaces 26 et 27 et au voisinage des surfaces 28 et 29, perpendiculairement aux bords 23 et 24. Ces faces 36 et 37 permettent de guider l'extrémité 30a du tournevis 30 en empêchant un positionnement en travers de cette extrémité.

Grâce à l'invention, aucun élément ou dispositif de verrouillage ne demeure sur la face avant de la carte une fois celle-ci installée, un organe de manoeuvre tel qu'un tournevis pouvant être utilisé pour insérer ou extraire un nombre très important de cartes.

L'invention présente l'avantage particulier d'être compatible avec tous les boîtiers équipés de profil à encoches, indépendamment du type des moyens de connexions 3 ou 6 et de leur nombre, ce qui permet une grande standardisation.

En outre, l'invention permet d'intégrer sur la surface 2b des dispositifs conformes aux normes en vigueur tel qu'un système de détrompage, un dispositif de centrage final et un moyen de décharge statique sans sur-coût important car ces dispositifs peuvent être crées par ajout ou suppression de matière, alors que la face avant 2 est monobloc.

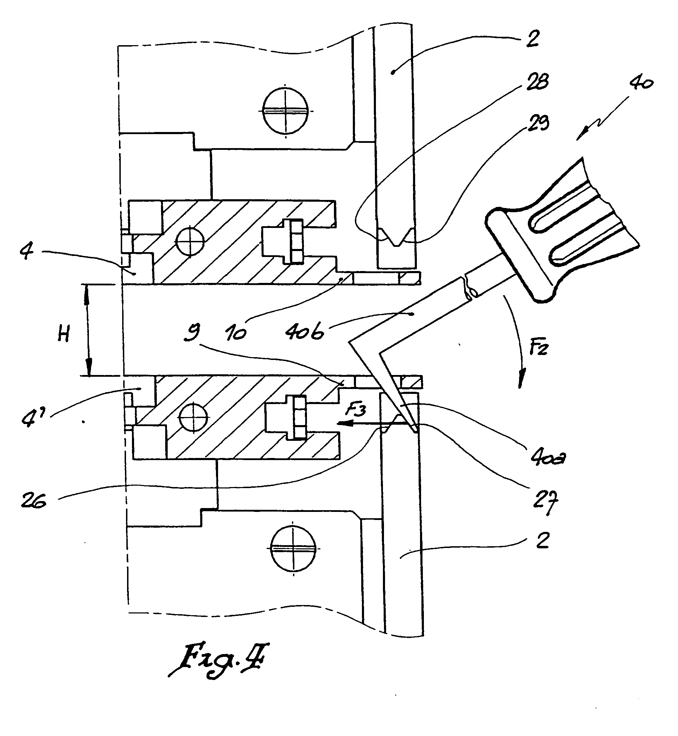

Dans la configuration représentée par la figure 4, deux boîtiers 4 et 4' sont superposés. Dans ce cas, un outillage spécifique 40 est utilisé pour accéder aux surfaces 26 et 27 de la face avant 2 d'une carte installée dans le boîtier inférieur 4' ou aux surfaces inférieures 28 et 29 d'une face avant 2 d'une carte installée dans le boîtier supérieur 4. L'outillage 40 comprend une extrémité 40a analogue à celle du tournevis 30 représentée aux figures 2 et 3 mais sa tige 40b est coudée à angle droit. En pratique, l'angle de coudage de la tige 40b est adapté en tenant compte de la hauteur H de l'écart entre les boîtiers 4 et 4'.

Dans ce cas, la manipulation des cartes associées aux faces avant 2 a lieu principalement par une action au niveau des intervalles entre les différents boîtiers, ce qui est avantageux lorsque les boîtiers supérieur et inférieur sont en appui contre les faces supérieure ou inférieure d'une armoire ou d'un coffre, de telle sorte qu'il n'est pas possible d'accéder au bord supérieur d'une carte placée dans un boîtier supérieur et au bord inférieur d'une carte placée dans un boîtier inférieur.

L'invention a été représentée avec des surfaces d'appui 26 à 29 planes, c'est-à-dire adaptées à la forme de l'extrémité 30a du tournevis 30 qui dépend de la forme de la tête de la vis 32. Si un autre organe de manoeuvre est utilisé, par exemple un tournevis cruciforme, la géométrie des surfaces d'appui peut être adaptée en conséquence, ces surfaces pouvant être concaves.

L'invention est applicable à tous les types de cartes électroniques destinées à être montées dans un boîtier, fixe ou mobile, notamment un tiroir, une armoire ou un coffre.

## Revendications

1. Face avant (2) de carte électronique (1) prévue pour être insérée dans un boîtier (4) à travers une ouverture (8) dont au moins un bord est équipé d'un profil à encoches (9, 10) **caractérisée en ce qu'**elle comprend deux surfaces d'appui (26, 27 - 28, 29) inclinées (a) dans deux sens différents par rapport à un plan longitudinal (P) de ladite face avant (2), les deux surfaces d'appui sont prévues sur une partie (23, 24) de ladite face avant qui est disposée au voisinage dudit profil lorsque la carte électronique est installée dans le boîtier (4), les deux surfaces (26-29) d'appui sont aptes à coopérer avec un organe de manoeuvre (30) engagé à travers l'une desdites encoches (9a), l'une (27, 29) desdites surfaces d'appui étant apte à coopérer avec ledit organe de manoeuvre (30) pour l'insertion (F₂, F₃) de ladite carte (1) dans ledit boîtier, l'autre surface (26, 28) étant apte à coopérer avec ledit organe de manoeuvre pour l'extraction (F₄, F₅) de ladite carte.

2. Face avant selon la revendication 1, **caractérisée en ce que** lesdites deux surfaces d'appui (26-29) sont inclinées l'une par rapport à l'autre d'un angle (β) compris entre 60° et 90°, de préférence de l'ordre de 70°.

3. Face avant selon la revendication 2, **caractérisée en ce que** lesdites surfaces d'appui (26-29) sont dimensionnées et positionnées par rapport à ladite face avant (2) de telle sorte qu'un bord commun (34) auxdites surfaces d'appui est disposé sensiblement en regard du bord intérieur (9b) d'une encoche (9a) dudit profil (9, 10), en configuration montée de ladite carte (1) dans ledit boîtier (4).

4. Face avant selon l'une des revendications précédentes, **caractérisée en ce qu'**elle comprend au moins une surface d'appui (26-29) à chacune de ses extrémités (23, 24).

5. Face avant selon l'une des revendications précédentes, **caractérisée en ce que** ladite surface d'appui (26-29) est formée lors du moulage de ladite face avant (2).

6. Face avant selon l'une des revendications précédentes, **caractérisée en ce que** ladite surface d'appui (26-29) est ménagée légèrement en retrait (h) d'un bord supérieur (23) ou inférieur (24) de ladite face avant, dans l'épaisseur (e) de ladite face avant (2).

7. Carte électronique (1) destinée à être mise en place dans un boîtier (4), **caractérisée en ce qu'**elle est équipée d'une face avant (2) selon l'une des revendications précédentes.

8. Procédé d'insertion ou d'extraction d'une carte électronique (1), selon la revendication 7, dans ou d'un boîtier (4), à travers une ouverture (8) dont au moins un bord est équipé d'un profil à encoches (9, 10), **caractérisé en ce qu'**il consiste à introduire un organe de manoeuvre (30) à travers l'une des encoches (9a) dudit profil, à faire porter ledit organe contre une surface d'appui (26-29), ménagée sur une partie (23, 24) de la face avant (2) de ladite carte destinée à être disposée au voisinage dudit profil, et à exercer un effort de pivotement (F2, F4) dudit organe de manoeuvre par rapport à sa zone d'appui (30b) sur un bord (9b) de ladite encoche, de telle sorte qu'un effort (F3, F5) est transmis à ladite face avant, au niveau de ladite surface d'appui, dans une direction correspondant à l'insertion ou à l'extraction de ladite carte.

9. Procédé selon la revendication 8, **caractérisé en ce qu'**il consiste à utiliser comme organe de manoeuvre un tournevis (30) de manoeuvre d'une vis de fixation (32) de ladite carte (1) dans ledit boîtier (4).

## Claims

1. Front panel (2) of an electronic card (1) designed to be inserted into a housing unit (4) through an opening (8), at least one edge of which features a notched profile (9, 10), **characterized in that** it comprises two bearing surfaces (26, 27 - 28, 29) inclined (a) in two different directions relative to a longitudinal plane (P) of said front panel (2), the two bearing surfaces are provided on a portion (23, 24) of said front panel which is arranged in the vicinity of said profile when the electronic card is installed in the housing unit (4), the two bearing surfaces (26-29) are able to cooperate with an operating member (30) engaged through one of said notches (9a), one (27, 29) of said bearing surfaces being able to cooperate with said operating member (30) for the insertion (F₂, F₃) of said card (1) into said housing unit, the other surface (26, 28) being able to cooperate with said operating member for the extraction (F₄, F₅) of said card.

2. Front panel according to Claim 1, **characterized in that** said two bearing surfaces (26-29) are inclined relative to one another by an angle (β) of between 60° and 90°, preferably around 70°.

3. Front panel according to Claim 2, **characterized in that** said bearing surfaces (26-29) are dimensioned and positioned relative to said front panel (2) so that an edge (34) that is common to said bearing surfaces is arranged substantially facing the internal edge (9b) of a notch (9a) of said profile (9, 10), in the mounted configuration of said card (1) in said housing unit (4).

4. Front panel according to one of the preceding claims, **characterized in that** it comprises at least one bearing surface (26-29) at each of its ends (23, 24).

5. Front panel according to one of the preceding claims, **characterized in that** said bearing surface (26-29) is formed when moulding said front panel (2).

6. Front panel according to one of the preceding claims, **characterized in that** said bearing surface (26-29) is formed slightly set back (h) from a top edge (23) or bottom edge (24) of said front panel, in the thickness (e) of said front panel (2).

7. Electronic card (1) intended to be fitted in a housing unit (4), **characterized in that** it is equipped with a front panel (2) according to one of the preceding claims.

8. Method for inserting or extracting an electronic card (1), according to Claim 7, into or from a housing unit (4), through an opening (8), at least one edge of which features a notched profile (9, 10), **characterized in that** it consists in inserting an operating member (30) through one of the notches (9a) of said profile, in bringing said member to bear against a bearing surface (26-29), formed on a portion (23, 24) of the front panel (2) of said card intended to be arranged in the vicinity of said profile, and in exerting a pivoting force (F2, F4) on said operating member relative to its bearing region (30b) on an edge (9b) of said notch, such that a force (F3, F5) is transmitted to said front panel, at the level of said bearing surface, in a direction corresponding to the insertion or the extraction of said card.

9. Method according to Claim 8, **characterized in that** it consists in using, as operating member, a screwdriver (30) to operate a fixing screw (32) for fixing said card (1) in said housing unit (4).

## Patentansprüche

1. Frontseite (2) einer Elektronikkarte (1), die vorgesehen ist, um durch eine Öffnung (8) hindurch in ein Gehäuse (4) eingesetzt zu werden, von der mindestens ein Rand mit einem Profil mit Einschnitten (9, 10) ausgestattet ist, **dadurch gekennzeichnet, dass** sie zwei Auflageflächen (26, 27 - 28, 29) enthält, die in zwei verschiedene Richtungen bezüglich einer Längsebene (P) der Frontseite (2) geneigt sind (a), wobei die zwei Auflageflächen auf einem Teil (23, 24) der Frontseite vorgesehen sind, der in der Nähe des Profils angeordnet ist, wenn die Elektronikkarte in das Gehäuse (4) installiert ist, wobei die zwei Auflageflächen (26-29) mit einem Betätigungsorgan (30) zusammenwirken können, das durch einen der Einschnitte (9a) hindurch eingeführt wird, wobei eine (27, 29) der Auflageflächen mit dem Betätigungsorgan (30) zum Einsetzen (F₂, F₃) der Karte (1) in das Gehäuse zusammenwirken kann, während die andere Fläche (26, 28) mit dem Betätigungsorgan zum Herausziehen (F₄, F₅) der Karte zusammenwirken kann.

2. Frontseite nach Anspruch 1, **dadurch gekennzeichnet, dass** die zwei Auflageflächen (26-29) zueinander um einen Winkel (β) geneigt sind, der zwischen 60° und 90°, vorzugsweise in der Größenordnung von 70° liegt.

3. Frontseite nach Anspruch 2, **dadurch gekennzeichnet, dass** die Auflageflächen (26-29) bezüglich der Frontseite (2) so bemessen und positioniert sind, dass ein den Auflageflächen gemeinsamer Rand (34) in der in das Gehäuse (4) montierten Konfiguration der Karte (1) im Wesentlichen gegenüber dem Innenrand (9b) eines Einschnitts (9a) des Profils (9, 10) angeordnet ist.

4. Frontseite nach einem der vorhergehenden Ansprüche, **dadurch gekennzeichnet, dass** sie mindestens eine Auflagefläche (26-29) an jedem ihrer Enden (23, 24) enthält.

5. Frontseite nach einem der vorhergehenden Ansprüche, **dadurch gekennzeichnet, dass** die Auflagefläche (26-29) beim Formen der Frontseite (2) gebildet wird.

6. Frontseite nach einem der vorhergehenden Ansprüche, **dadurch gekennzeichnet, dass** die Auflagefläche (26-29) leicht von einem oberen (23) oder unteren Rand (24) der Frontseite rückversetzt (h) in der Dicke (e) der Frontseite (2) angeordnet ist.

7. Elektronikkarte (1), die dazu bestimmt ist, in ein Gehäuse (4) eingesetzt zu werden, **dadurch gekennzeichnet, dass** sie mit einer Frontseite (2) nach einem der vorhergehenden Ansprüche ausgestattet ist.

8. Verfahren zum Einführen oder zur Entnahme einer Elektronikkarte (1) nach Anspruch 7 in ein oder aus einem Gehäuse (4) durch eine Öffnung (8) hindurch, von der mindestens ein Rand mit einem Profil mit Einschnitten (9, 10) ausgestattet ist, **dadurch gekennzeichnet, dass** es darin besteht, ein Betätigungsorgan (30) durch einen der Einschnitte (9a) des Profils hindurch einzuführen, das Organ gegen eine Auflagefläche (26-29) anzulegen, die in einem Teil (23, 24) der Frontseite (2) der Karte ausgebildet ist, der dazu bestimmt ist, in der Nähe des Profils angeordnet zu werden, und eine Schwenkkraft (F2, F4) des Betätigungsorgans bezüglich seiner Auflagezone (30b) auf einem Rand (9b) der Einkerbung auszuüben, so dass eine Kraft (F3, F5) auf die Frontseite in Höhe der Auflagefläche in einer Richtung ausgeübt wird, die dem Einführen oder Herausnehmen der Karte entspricht.

9. Verfahren nach Anspruch 8, **dadurch gekennzeichnet, dass** es darin besteht, als Betätigungsorgan einen Schraubendreher (30) zur Betätigung einer Befestigungsschraube (32) der Karte (1) im Gehäuse (4) zu verwenden.
